# EUROPEAN PATENT APPLICATION

(11) **EP 3 407 685 A1**
(43) Date of publication of application: **28.11.2018**
(21) Application number: 16886232.4
(22) Date of filing: 27.12.2016
(51) Int. Cl.: H05K 1/02

(54) **CIRCUIT BOARD**

(30) Priority: 20.01.2016 JP 2016008541
(71) Applicant: Panasonic Intellectual Property Management Co., Ltd., Osaka-shi, Osaka 540-6207 (JP)
(72) Inventor: MORITA, Yosuke, Osaka-shi, Osaka 540-6207 (JP)
(74) Representative: Appelt, Christian W.
(86) International application number: PCT/JP2016/005224
(87) International publication number: WO 2017/125988

(57) **Abstract**

A circuit board includes a main body section, a wiring pattern, and a through-hole. The wiring pattern is disposed on a surface of the main body section. The through-hole is formed in a site of the main body section. The site is provided with the wiring pattern. The through-hole has a first end and a second end. The wiring pattern includes a first surface wiring pattern and an inner surface wiring pattern. The first surface wiring pattern is formed on the surface of the main body section adjacent to the first end. The inner surface wiring pattern is connected to the first surface wiring pattern and formed on an inner surface of the through-hole. The through-hole includes a smallest section between the first end and the second end in a passing-through direction. The smallest section is smallest in area of a cross section perpendicular to the passing-through direction of the through-hole. The inner surface wiring pattern is provided from the first end to a position beyond the smallest section.

## Description

### TECHNICAL FIELD

The present disclosure relates to a circuit board.

### BACKGROUND

A conventionally known circuit board includes a main body section and a wiring pattern on a surface of the main body section (see, for example, PTL 1). At least the surface of the main body section has insulating properties.

### Citation List

### Patent Literature

PTL 1: Unexamined Japanese Patent Publication No. 2012-174898

### SUMMARY

A circuit board according to the present disclosure includes a main body section, a wiring pattern, and a through-hole. The main body section includes a first wall and a second wall connected to and intersected with the first wall. The first wall is to be mounted with an electronic component. At least a surface of the main body section has insulating properties. The wiring pattern is disposed on the surface of the main body section. The through-hole is formed in a site of the main body section. The site is provided with the wiring pattern.

The through-hole has a first end and a second end. The wiring pattern includes a first surface wiring pattern and an inner surface wiring pattern. The first surface wiring pattern is on a first surface with the first end among the surface of the main body section. The inner surface wiring pattern is connected to the first surface wiring pattern and is on an inner surface of the through-hole.

The through-hole includes a smallest section. The smallest section is smallest in area of a cross section of the through-hole. The cross section is perpendicular to a passing-through direction from the first end to the second end.

The inner surface wiring pattern is provided from the first end to a position beyond the smallest section.

The present disclosure provides a circuit board capable to prevent a wiring pattern from peeling off a main body section with increased reliability.

### BRIEF DESCRIPTION OF DRAWINGS

FIG. 1 is a schematic perspective view illustrating a circuit board according to an exemplary embodiment of the present disclosure.
FIG. 2 is a schematic plan view illustrating the circuit board according to the exemplary embodiment of the present disclosure.
FIG. 3 is a schematic plan view illustrating the circuit board according to the exemplary embodiment of the present disclosure, on which an electronic component is mounted.
FIG. 4 is a side view illustrating the circuit board according to the exemplary embodiment of the present disclosure, on a surface of which a wiring section is formed.
FIG. 5 is a side view illustrating the circuit board according to the exemplary embodiment of the present disclosure, on a surface of which no wiring section is formed.
FIG. 6 is a cross-sectional view taken along line VI-VI of FIG. 2.
FIG. 7 is an enlarged cross-sectional view of a B part in FIG. 6.
FIG. 8 is an enlarged cross-sectional view illustrating a part of a first modification of the circuit board according to the exemplary embodiment of the present disclosure, the part of the first modification corresponding to the part in FIG. 7.
FIG. 9 is an enlarged cross-sectional view illustrating a part of a second modification of the circuit board according to the exemplary embodiment of the present disclosure, the part of the second modification corresponding to the part in FIG. 7.
FIG. 10 is an enlarged cross-sectional view illustrating a part of a third modification of the circuit board according to the exemplary embodiment of the present disclosure, the part of the third modification corresponding to the part in FIG. 7.

### DESCRIPTION OF EMBODIMENT

Prior to describing an exemplary embodiment of the present disclosure, a problem with a conventional circuit board is briefly described. In the conventional art described above, the wiring pattern is merely formed on the surface of the main body section and thus the wiring pattern may peel off the main body section.

The present disclosure provides a circuit board capable to prevent a wiring pattern from peeling off a main body section with increased reliability.

An exemplary embodiment of the present disclosure will be described in detail with reference to the drawings. In the following description, a three-dimensional circuit board is taken as an example of the circuit board.

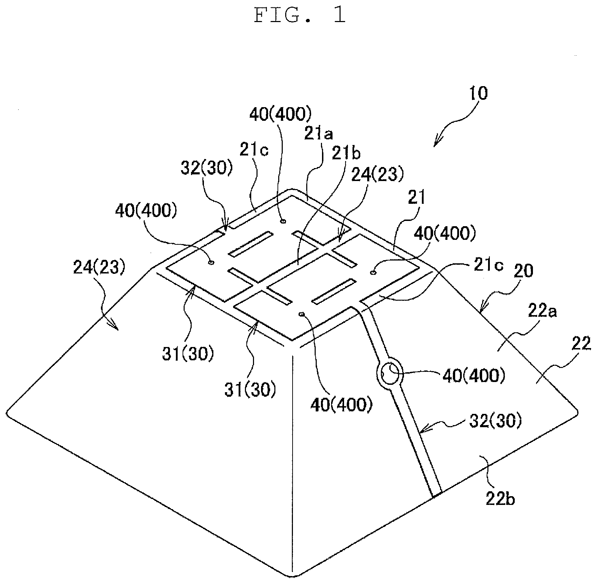

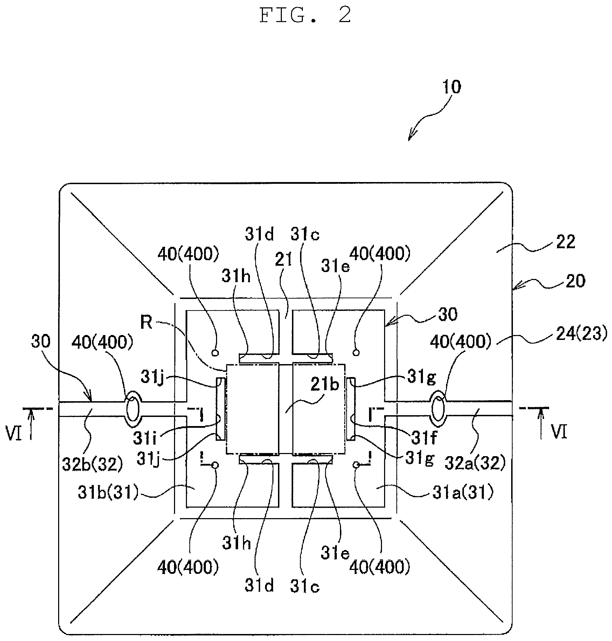

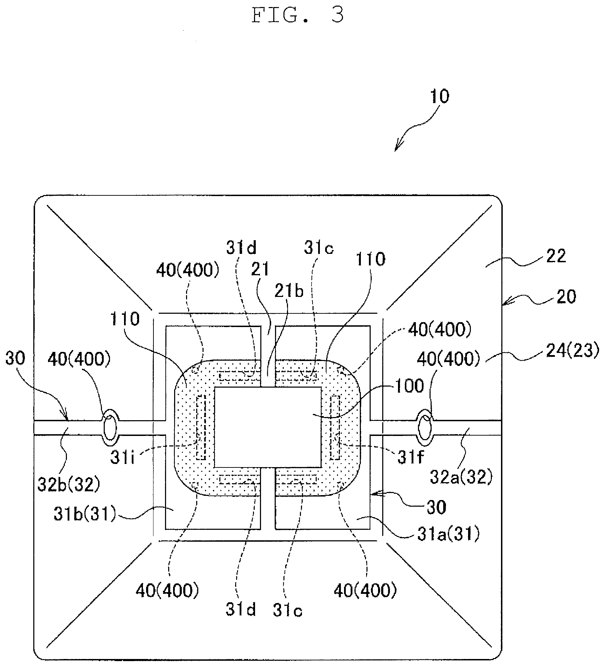

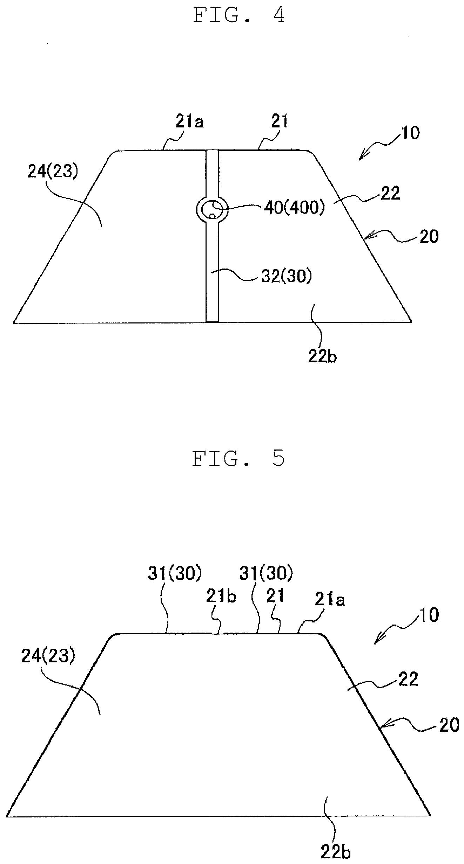

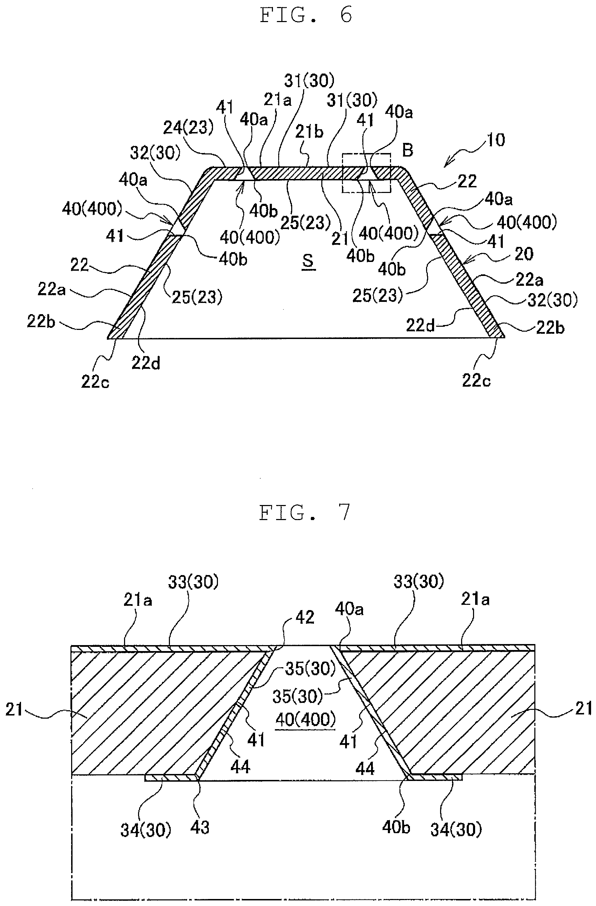

FIG. 1 is a schematic perspective view illustrating a circuit board according to an exemplary embodiment of the present disclosure and FIG. 2 is a schematic plan view illustrating the circuit board according to the exemplary embodiment of the present disclosure. FIG. 3 is a schematic plan view illustrating the circuit board according to the exemplary embodiment of the present disclosure, on which an electronic component is mounted. FIG. 4 is a side view illustrating the circuit board according to the exemplary embodiment of the present disclosure, on a surface of which a wiring section is formed. FIG. 5 is a side view illustrating the circuit board according to the exemplary embodiment of the present disclosure, on a surface of which no wiring section is formed. FIG. 6 is a cross-sectional view taken along line VI-VI of FIG. 2. FIG. 7 is an enlarged cross-sectional view of a B part in FIG. 6.

With reference to FIG. 1, three-dimensional circuit board (circuit board) 10 according to the present exemplary embodiment includes main body section 20. Main body section 20 is made from resin, ceramics, or other material such that at least surface 23 of main body section 20 has insulating properties, for example.

In this exemplary embodiment, main body section 20 is a case having a substantially truncated quadrangular pyramid shape, i.e. a three-dimensional shape (see FIG. 1).

Specifically, main body section 20 includes plate-shaped top wall 21 (an example of a first wall) having a substantially square shape and plate-shaped peripheral wall 22 (an example of a second wall) connecting to and being disposed around top wall 21 (see FIG. 6). In other words, peripheral wall 22 is disposed so as to connect to and intersect with top wall 21. In this exemplary embodiment, peripheral wall 22 is formed so as to surround an entire perimeter of top wall 21. Peripheral wall 22 is shaped so that four flat parts are integrated. Each of the four flat parts has a shape of substantially isosceles trapezoid whose short side (upper side) is connected to respective side of top wall 21 (see FIGS. 1, 4, and 5). In other words, peripheral wall 22 is shaped like a square tube whose cross section expands (widens toward the outside) in area along with a downward of peripheral wall 22.

In this exemplary embodiment, above-described square tube-shaped peripheral wall 22 and top wall 21 are integrally formed to be main body section 20. As a result, with reference to FIG. 6, main body section 20 provides space S inside such that space S has an opening at its bottom and a cross section of space S expands in area along with a downward of main body section 20.

Three-dimensional wiring pattern 30 is formed on surface 23 of main body section 20. This wiring pattern 30 and main body section 20 constitute three-dimensional circuit board (circuit board) 10.

This wiring pattern 30 can be formed directly on surface 23 of main body section 20 by molded interconnect device (MID) technology, for example.

The MID is a three-dimensionally molded circuit component, that is a three-dimensionally molded body such as an injection-molded body whose surface is integrated with an electric circuit. In contrast to conventional two-dimensional circuit technology, this MID technology enables a formation of electric circuits to inclines, vertical planes, curved surfaces, through-holes inside molded bodies, and other locations.

The MID technology can be achieved by using microscopic integrated processing technology (MIPTEC), for example. The MIPTEC involves the use of a molded-surface activation technology, laser-patterning technique, and other approaches at the time of forming an electric circuit on a surface of an injection-molded body. Thus, this MIPTEC technology provides three-dimensional mounting devices on which fine patterns and bare chips can be mounted.

Laser direct structuring (LDS) technique can be used for the MIDs. The LDS technique involves projecting a laser beam along a wiring pattern and getting a layer of plating to be deposited only on a part irradiated with the laser beam so as to form an electric circuit. This LDS technique can be applied to materials in addition to MIPTEC-compatible materials such as polyphthalamide (PPA) and other resins, as well as ceramics and other molding compounds. For example, the LDS technique can be applied to various resins and other molding compounds including liquid crystal polymers (LCPs) with high heat resistance and high-frequency performance, polycarbonates (PCs) with dimensional stability, and polyamides (PAs) with high heat resistance and good circuit adhesion.

By using this LDS technique, electric circuits can be formed on not only increased variety of molding compounds as described above but also relatively large bodies (molded bodies).

The MIDs can be produced by other techniques such as the two-shot molding technique, which involves two-stage injection molding to manufacture molded bodies.

Alternatively, a wiring pattern can be formed on the main body section using a thin copper film formed by copper sputtering or the like.

With reference to FIG. 2, wiring pattern 30 includes land section 31 and wiring section 32 connected to land section 31. Electronic components 100, such as a relay, a capacitor, a coil, and a transformer, are mounted on land section 31. Wiring pattern 30 is formed so as to extend from top wall 21 to peripheral wall 22.

Land section 31 is formed on outer surface 24 of main body section 20. Specifically, two land parts 31a, 31b are formed on top face 21a of top wall 21, which is a flat surface extending substantially horizontally, such that the two land parts are electrically isolated from each other. In other words, two land parts 31a, 31b are separated from each other on a flat portion of outer surface 24 of main body section 20. One of two land parts 31a, 31b acts as a positive (+) electrode and the other land part acts as a negative (-) electrode.

In this exemplary embodiment, two land parts 31a, 31b each have substantially rectangular shape in a plan view. The two land parts are disposed separately from each other such that respective long sides of the two land parts face each other. Thus, exposed area 21b extending linearly along a longitudinal direction of land parts 31a, 31b is formed at a central portion of top face 21a of top wall 21.

A pair of cutouts 31c, 31c each extending in a transverse direction are formed in a long side of one land part 31a which is opposed to other land part 31b. And the pair of cutouts 31c, 31c are separated from each other in the longitudinal direction of the land parts. Similarly, a pair of cutouts 31d, 31d each extending in a transverse direction are formed in a long side of other land part 31b which is opposed to one land part 31a. And the pair of cutouts 31d, 31d are separated from each other in the longitudinal direction of the land parts.

In the transverse direction, one of the pair of cutouts 31c, 31c faces one of the pair of cutouts 31d, 31d. At the same time, the other of the pair of cutouts 31c, 31c faces the other of the pair of cutouts 31d, 31d.

Recess 31f extending in the longitudinal direction is formed in one land part 31a. Recess 31f is disposed at a position far away from the long side of one land part 31a than inner ends 31e, 31e of the pair of cutouts 31c, 31c in the transverse direction. Meanwhile, in the longitudinal direction, recess 31f is disposed at a position between the pair of cutouts 31c, 31c. In other words, both ends 31g, 31g of recess 31f lengthwise are located at a position inside a region between the pair of cutouts 31c, 31c in the longitudinal direction.

Similarly, recess 31i extending in the longitudinal direction is formed in other land part 31b. Recess 31i is disposed at a position far away from the long side of other land part 31b than inner ends 31h, 31h of the pair of cutouts 31d, 31d in the transverse direction. Meanwhile, in the longitudinal direction, recess 31i is also disposed at a position between the pair of cutouts 31d, 31d. In other words, both ends 31j, 31j of recess 31i lengthwise are located at a position inside a region between the pair of cutouts 31d, 31d in the longitudinal direction.

Consequently, the pair of cutouts 31c, 31c, the pair of cutouts 31d, 31d, recess 31f, and recess 31i can define region (component mount region) R having a substantially rectangular shape formed at the central portion of top face 21a of top wall 21 (see FIG. 2).

When electronic components 100 are mounted in this region R by solder 110 or other bonding material, the circuit board establishes electrical connection between land part 31a and land part 31b via electronic components 100. And thus electricity is supplied to electronic components 100 (see FIG. 3). If the pair of cutouts 31c, 31c, the pair of cutouts 31d, 31d, recess 31f, and recess 31i are filled with solder 110, electronic components 100 are more firmly mounted on the surface in land section 31.

Meanwhile, wiring section 32 includes wiring part 32a connected to land part 31a and wiring part 32b connected to land part 31b. Wiring parts 32a and 32b are formed electrically separated from each other (see FIG. 2).

Specifically, wiring part 32a is connected to a transversely outer side of land part 31a at a central portion of land part 31a in the longitudinal direction. Wiring part 32a extends substantially linearly from end 21c of top face 21a of top wall 21 to bottom edge 22b of outer lateral surface 22a of peripheral wall 22.

Similarly, wiring part 32b is connected to a transversely outer side of land part 31b at a central portion of land part 31b in the longitudinal direction. Wiring part 32b extends substantially linearly from end 21c of top face 21a of top wall 21 to bottom edge 22b of outer lateral surface 22a of peripheral wall 22.

As described above, in this exemplary embodiment, wiring part 32a and wiring part 32b are each formed so as to have a curved linear shape (a three-dimensional shape) (see FIG. 1).

Any of wiring part 32a and wiring part 32b may run along lower end surface 22c of peripheral wall 22 and reach inner lateral surface 22d.

Wiring pattern 30 (land section 31 and wiring section 32) may have parts of any shapes and any numbers of installed parts other than the shapes and the numbers of the installed parts described above.

In this exemplary embodiment, the circuit board is designed to prevent wiring pattern 30 from peeling off main body section 20 with increased reliability.

Specifically, through-hole 40 is formed in a site of main body section 20 where wiring pattern 30 is disposed, and wiring pattern 30 is formed as well on inner surface 41 of through-hole 40 (see FIGS. 2 and 6). Such through-hole 40 can be formed by applying etching to main body section 20, for example.

In this exemplary embodiment, as shown in FIG. 2, one through-hole 40 is formed in a region in which wiring part 32a is disposed, while one through-hole 40 is formed in a region in which wiring part 32b is disposed. Two through-holes 40, 40 are formed in a region in which land part 31a is disposed, while two through-holes 40, 40 are formed in a region in which land part 31b is disposed.

When electronic components 100 are mounted in land section 31, four through-holes 40 formed in a region in which land section 31 is disposed are positioned in an area around electronic components 100 (at four corners near component mount region R) in land section 31 (see FIG. 2).

The circuit board ensures that wiring pattern 30 is formed as well on inner surface 41 of each through-hole 40.

In this exemplary embodiment, each through-hole 40 has a shape of substantially truncated cone whose inner surface 41 is constituted by inclined surface 44 (see FIGS. 6 and 7).

Specifically, each through-hole 40 is formed such that the cross-sectional area of through-hole 40 gradually changes along with a passing-through direction from one end 40a (an example of a first end), which is an end adjacent to outer surface 24 of main body section 20, to other end 40b (an example of a second end), which is an end adjacent to inner surface 25 of main body section 20.

In this exemplary embodiment, the cross-sectional area of through-holes 40 formed in land section 31 gradually increases along with the passing-through direction from one end 40a to other end 40b. Meanwhile, the cross-sectional area of through-holes 40 formed in wiring section 32 gradually decreases along with the passing-through direction from one end 40a to other end 40b.

As a result, in through-holes 40 formed in land section 31, an area of a cross section perpendicular to the passing-through direction is smallest at one end 40a and hence each through-hole 40 has smallest section 42 at one end 40a. The area of the cross section perpendicular to the passing-through direction is largest at other end 40b and hence each through-hole 40 has largest section 43 at other end 40b (see FIG. 7).

Meanwhile, in through-holes 40 formed in wiring section 32, an area of a cross section perpendicular to the passing-through direction is largest at one end 40a and hence each through-hole 40 has largest section 43 at one end 40a (see FIG. 6). The area of the cross section perpendicular to the passing-through direction is smallest at other end 40b and hence each through-hole 40 has smallest section 42 at other end 40b (see FIG. 6).

As described above, in this exemplary embodiment, all through-holes 40 each include smallest section 42 having the smallest area. Smallest section 42 is positioned between one end 40a and other end 40b in the passing-through direction. In other words, through-hole 400 is a non-equal area through-hole having an area smaller than the area of other sections between one end 40a and other end 40b.

In this exemplary embodiment, a region between one end 40a and other end 40b represents a region including one end 40a and other end 40b.

Wiring pattern 30 formed on inner surface 41 of through-hole 400 (through-holes 40) is contiguously and integrally formed with wiring pattern 30 formed on outer surface 24 of main body section 20 (see FIG. 7).

In other words, wiring pattern 30 includes one surface wiring pattern 33 (an example of a first surface wiring pattern) and inner surface wiring pattern 35. One surface wiring pattern 33 is formed on a surface (outer surface 24) of main body section 20 adjacent to one end 40a of through-hole 400 (through-holes 40). Inner surface wiring pattern 35 is connected to one surface wiring pattern 33 and formed on inner surface 41 of through-hole 400 (through-holes 40).

Inner surface wiring pattern 35 is provided from one end 40a to a position beyond smallest section 42 on inner surface 41 of through-hole 400 in which smallest section 42 is formed.

In this exemplary embodiment, wiring pattern 30 further includes other surface wiring pattern 34 (an example of a second surface wiring pattern). Other surface wiring pattern 34 is formed on a surface (inner surface 25) of main body section 20 adjacent to other end 40b of through-hole 400 and is connected to inner surface wiring pattern 35 formed on inner surface 41 of through-hole 400 in which smallest section 42 is formed.

In other words, one surface wiring pattern 33, inner surface wiring pattern 35, and other surface wiring pattern 34 are contiguously and integrally formed with one another.

Accordingly, in this exemplary embodiment, wiring pattern 30 is formed on main body section 20 so as to extend from outer surface 24 and run along through-hole 400 to reach inner surface 25. Thus, inner surface 41 of through-hole 400 is entirely covered with wiring pattern 30 (inner surface wiring pattern 35).

As described above, circuit board 10 according to the present exemplary embodiment includes main body section 20, wiring pattern 30 disposed on surface 23 of main body section 20, and through-holes 40 each formed in a site of main body section 20 where wiring pattern 30 is disposed.

Wiring pattern 30 includes one surface wiring pattern 33 and and inner surface wiring pattern 35. One surface wiring pattern 33 is formed on a surface (outer surface 24) of main body section 20 adjacent to one end 40a of through-holes 40. Inner surface wiring pattern 35 is connected to one surface wiring pattern 33 and formed on inner surfaces 41 of through-holes 40.

Through-holes 40 each include through-hole 400 having smallest section 42 that is smallest in area of a cross section perpendicular to the passing-through direction. Smallest section 42 is positioned between one end 40a and other end 40b in the passing-through direction.

Inner surface wiring pattern 35 is provided from one end 40a to a position beyond smallest section 42 on inner surface 41 of through-hole 400 in which smallest section 42 is formed.

This configuration allows wiring pattern 30 to get caught on a protrusion formed near smallest section 42 and hence wiring pattern 30 exhibits an anchor effect. This anchor effect enhances adhesion of wiring pattern 30 to main body section 20. As a result, the circuit board prevents wiring pattern 30 from peeling off main body section 20.

This configuration according to the present exemplary embodiment provides circuit board 10 that prevents wiring pattern 30 from peeling off main body section 20 with increased reliability.

In this exemplary embodiment, wiring pattern 30 includes other surface wiring pattern 34. Other surface wiring pattern 34 is formed on a surface (inner surface 25) of main body section 20 adjacent to other end 40b of through-hole 400 and is connected to inner surface wiring pattern 35 formed on inner surface 41 of through-hole 400 in which smallest section 42 is formed.

This configuration enables wiring pattern 30 to exhibit an anchor effect more effectively and thus the circuit board prevents wiring pattern 30 from peeling off main body section 20 with increased reliability.

In this exemplary embodiment, main body section 20 has a three-dimensional shape.

This configuration allows circuit board 10 to have both a mechanical function as a mechanical component and an electrical function as a circuit board. This in turn allows reductions in device size and a number of components.

In this exemplary embodiment, wiring pattern 30 includes land section 31 where electronic components 100 are mounted and wiring section 32 connected to land section 31. Through-hole 400, in which smallest section 42 is formed, is formed in land section 31.

This configuration, owing to through-hole 400 formed in land section 31, enhances adhesion of land section 31 to main body section 20. As a result, the circuit board prevents land section 31 from peeling off main body section 20 with increased reliability.

In this exemplary embodiment, through-hole 400, in which smallest section 42 is formed, is formed near the periphery of electronic components 100 in land section 31 while electronic components 100 are mounted in land section 31.

This configuration allows through-hole 400 to be filled with solder 110 that is used at the time of mounting electronic components 100 and thus enhances adhesion of land section 31 to main body section 20.

If through-hole 400, in which smallest section 42 is formed, is formed at an edge of land section 31, land section 31 can exhibit enhanced adhesion to main body section 20 at its edge, which is likely to peel off.

In this exemplary embodiment, through-hole 400, in which smallest section 42 is formed, is formed in wiring section 32.

This configuration, owing to through-hole 400 formed in wiring section 32, enhances adhesion of wiring section 32 to main body section 20. As a result, the circuit board prevents land section 31 from peeling off main body section 20 with increased reliability.

### (First modification)

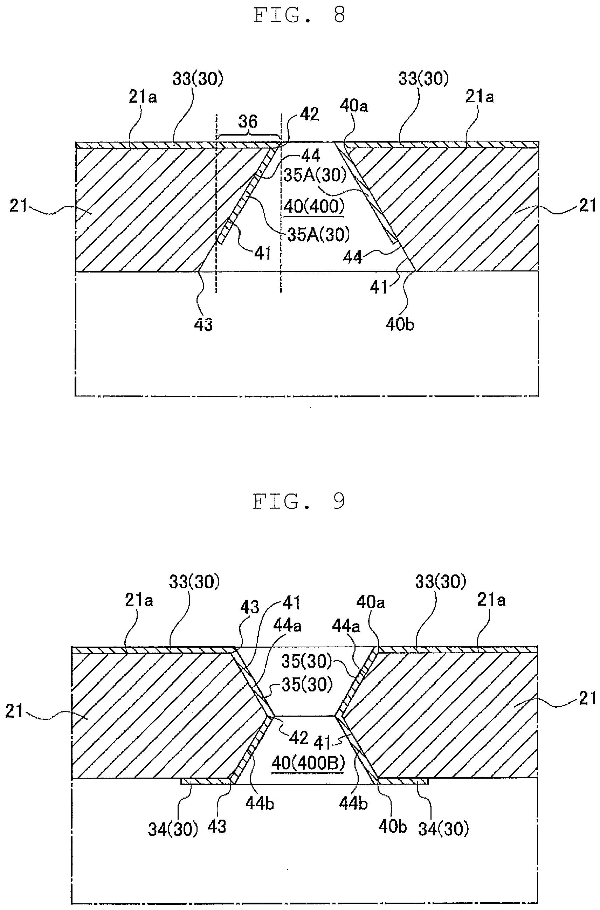

FIG. 8 is an enlarged cross-sectional view illustrating a part of a first modification of the circuit board according to the exemplary embodiment of the present disclosure, the part of the first modification corresponding to the part in FIG. 7.

In the exemplary embodiment described above, wiring pattern 30 is formed on main body section 20 so as to extend from outer surface 24 and run along through-hole 400 to reach inner surface 25. In other words, inner surface 41 is entirely covered with inner surface wiring pattern 35 in this example. However, with reference to FIG. 8, inner surface wiring pattern 35A may run partway on inner surface 41 of through-hole 400 such that inner surface wiring pattern 35 is not formed on a region of inner surface 41 near other end 40b.

In this modification, inner surface wiring pattern 35A is provided so as to reach a position beyond smallest section 42 on inner surface 41 of through-hole 400 in which smallest section 42 is formed.

In other words, wiring pattern 30 is formed such that overlapping region 36 where a part of wiring pattern 30 overlaps with another part viewing in a passing-through (depth) direction is formed at at least an innermost side of a region between the innermost side and an outermost side of through-hole 400. One surface wiring pattern 33 and inner surface wiring pattern 35 are contiguously and integrally formed with each other to be wiring pattern 30.

A circuit board having this configuration can exhibit almost the same action and effect as those of circuit board 10 shown in the exemplary embodiment described above.

### (Second modification)

FIG. 9 is an enlarged cross-sectional view illustrating a part of a second modification of the circuit board according to the exemplary embodiment of the present disclosure, the part of the second modification corresponding to the part in FIG. 7.

The circuit board may include through-hole 400B that has a shape shown in FIG. 9. Specifically, through-hole 400B is shaped substantially into a pair of truncated cones that are coupled to each other, with respective center axes being substantially identical. One of the truncated cones has inner surface 41 adjacent one end 40a as one inclined surface 44a, whereas the other truncated cone has inner surface 41 adjacent other end 40b as other inclined surface 44b.

In other words, a cross-sectional area perpendicular to a passing-through direction of through-hole 400B gradually decreases along with the passing-through direction from one end 40a (an end of main body section 20 adjacent to outer surface 24) to a central portion of through-hole 400B. And the cross-sectional area perpendicular to the passing-through direction of through-hole 400B gradually decreases along with the passing-through direction from other end 40b (an end of main body section 20 adjacent to inner surface 25) to the central portion.

Thus, in through-hole 400B, the cross-sectional area perpendicular to the passing-through direction of through-hole 400B is smallest at the central portion of through-hole 400B in the depth direction. Hence through-hole 400B has smallest section 42 at the central portion of through-hole 400B. The cross-sectional area perpendicular to the passing-through direction of through-hole 400B is largest at one end 40a and/or other end 40b. Hence through-hole 40 may have largest sections 43 at one end 40a and other end 40b, respectively. One end 40a and other end 40b are not necessarily the same in area size. One of one end 40a and other end 40b may have a larger area size than the other. In this case, the one of one end 40a and other end 40b which has the larger area size is largest section 43.

Wiring pattern 30 formed on inner surface 41 of through-hole 400B (through-holes 40) is contiguously and integrally formed with wiring pattern 30 formed on outer surface 24 of main body section 20.

In other words, wiring pattern 30 includes one surface wiring pattern 33 and inner surface wiring pattern 35. One surface wiring pattern 33 is formed on a surface (outer surface 24) of main body section 20 adjacent to one end 40a of through-hole 400B (through-holes 40). Inner surface wiring pattern 35 is connected to one surface wiring pattern 33 and formed on inner surface 41 of through-hole 400B (through-holes 40).

Inner surface wiring pattern 35 is from one end 40a to a position beyond smallest section 42 on inner surface 41 of through-hole 400B in which smallest section 42 is formed.

In FIG. 9 as well, wiring pattern 30 further includes other surface wiring pattern 34. Other surface wiring pattern 34 is formed on a surface (inner surface 25) of main body section 20 adjacent to other end 40b of through-hole 400B and is connected to inner surface wiring pattern 35 formed on inner surface 41 of through-hole 400B in which smallest section 42 is formed.

In other words, one surface wiring pattern 33, inner surface wiring pattern 35, and other surface wiring pattern 34 are contiguously and integrally formed with one another.

Accordingly, in FIG. 9 as well, wiring pattern 30 is formed on main body section 20 so as to extend from outer surface 24 and run along through-hole 400B to reach inner surface 25. Thus, inner surface 41 of through-hole 400B is entirely covered with wiring pattern 30 (inner surface wiring pattern 35).

A circuit board having this configuration can exhibit almost the same action and effect as those of circuit board 10 shown in the exemplary embodiment described above.

In through-hole 400B as well, inner surface wiring pattern 35 may run partway on inner surface 41 of through-hole 400B such that inner surface wiring pattern 35 is not formed on a region of inner surface 41 near other end 40b.

In this case, inner surface wiring pattern 35 is provided so as to reach a position beyond smallest section 42 on inner surface 41 of through-hole 400B in which smallest section 42 is formed.

In other words, wiring pattern 30 is formed such that an overlapping region where a part of wiring pattern 30 overlaps with another part viewing in the passing-through (depth) direction is formed at at least an innermost side of a region between the innermost side and an outermost side of through-hole 400B. One surface wiring pattern 33 and inner surface wiring pattern 35 are contiguously and integrally formed with each other.

### (Third modification)

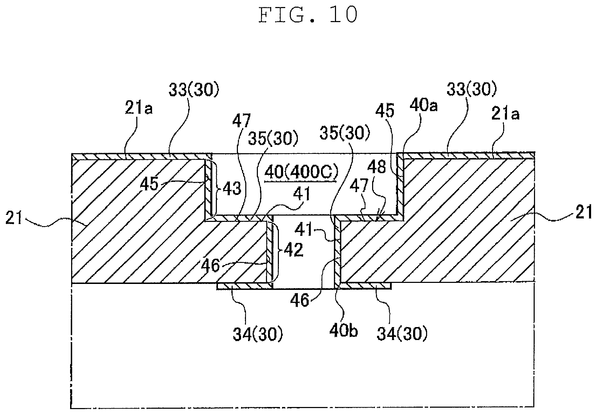

FIG. 10 is an enlarged cross-sectional view illustrating a part of a third modification of the circuit board according to the exemplary embodiment of the present disclosure, the part of the third modification corresponding to the part in FIG. 7.

The circuit board may include through-hole 400C that has a shape shown in FIG. 10. Specifically, through-hole 400C is shaped substantially into a pair of cylinders that are coupled to each other, with respective center axes being substantially identical. One of the cylinders has inner surface 41 adjacent one end 40a as large-diameter lateral surface 45, whereas the other cylinder has inner surface 41 adjacent other end 40b as small-diameter lateral surface 46. Thus, step portion 48 is formed on through-hole 400C.

In other words, with reference to FIG. 10, inner surface 41 of through-hole 400C includes large-diameter lateral surface 45 located at a side adjacent to one end 40a, small-diameter lateral surface 46 located at a side adjacent to other end 40b, and inner floor 47 that connects between large-diameter lateral surface 45 and small-diameter lateral surface 46.

Accordingly, a cross-sectional area perpendicular to a passing-through direction of through-hole 400C is relatively large and substantially constant along the passing-through direction from one end 40a (an end of main body section 20 adjacent to outer surface 24) to a central portion of the through-hole. And the cross-sectional area perpendicular to the passing-through direction of through-hole 400C is relatively small and substantially constant along the passing-through direction from other end 40b (an end of main body section 20 adjacent to inner surface 25) to the central portion.

As a result, in through-hole 400C, the cross-sectional area perpendicular to the passing-through direction of through-hole 400C is smallest over a span with the relatively small and substantially constant cross-sectional area (a segment with small-diameter lateral surface 46). And hence the span constitutes smallest section 42. The cross-sectional area perpendicular to the passing-through direction of through-hole 400C is largest over a span with the relatively large and substantially constant cross-sectional area (a segment with large-diameter lateral surface 45). And hence the span constitutes largest section 43.

Wiring pattern 30 formed on inner surface 41 of through-hole 400C (through-holes 40) is contiguously and integrally formed with wiring pattern 30 formed on outer surface 24 of main body section 20.

In other words, wiring pattern 30 includes one surface wiring pattern 33 and inner surface wiring pattern 35. One surface wiring pattern 33 is formed on a surface (outer surface 24) of main body section 20 adjacent to one end 40a of through-hole 400C (through-holes 40). Inner surface wiring pattern 35 is connected to one surface wiring pattern 33 and formed on inner surface 41 of through-hole 400C (through-holes 40).

Inner surface wiring pattern 35 is from one end 40a to a position beyond smallest section 42 on inner surface 41 of through-hole 400C in which smallest section 42 is formed.

In FIG. 10 as well, wiring pattern 30 further includes other surface wiring pattern 34. Other surface wiring pattern 34 is formed on a surface (inner surface 25) of main body section 20 adjacent to other end 40b of through-hole 400C and is connected to inner surface wiring pattern 35 formed on inner surface 41 of through-hole 400C in which smallest section 42 is formed.

In other words, one surface wiring pattern 33, inner surface wiring pattern 35, and other surface wiring pattern 34 are contiguously and integrally formed with one another.

Accordingly, in FIG. 10 as well, wiring pattern 30 is formed on main body section 20 so as to extend from outer surface 24 and run along through-hole 400C to reach inner surface 25. Thus, inner surface 41 of through-hole 400C is entirely covered with wiring pattern 30 (inner surface wiring pattern 35).

A circuit board having this configuration can exhibit almost the same action and effect as those of circuit board 10 shown in the exemplary embodiment described above.

In through-hole 400C as well, inner surface wiring pattern 35 may run partway on inner surface 41 of through-hole 400C such that inner surface wiring pattern 35 is not formed on a region of inner surface 41 near other end 40b.

If wiring pattern 30 is constituted only by one surface wiring pattern 33 and inner surface wiring pattern 35 which are contiguously and integrally formed with each other, no overlapping region is formed between an innermost side and an outermost side of through-hole 400C. Thus, wiring pattern 30 needs to include other surface wiring pattern 34 and inner surface wiring pattern 35 which are contiguously and integrally formed with each other.

It is satisfactory that inner surface wiring pattern 35 is provided so as to reach a position beyond smallest section 42 on inner surface 41 of through-hole 400C in which smallest section 42 is formed, that is, so as to ensure that inner surface wiring pattern 35 exists at least on inner floor 47.

In this configuration, an overlapping region where these wiring patterns overlap each other viewing in the passing-through (depth) direction is formed at at least the innermost side between the innermost side and the outermost side of through-hole 400C.

The scope of the present disclosure should not be limited to the exemplary embodiment described above, and should include various modifications and alterations.

For example, a circuit board of the present disclosure may be designed by suitably combining components shown in the exemplary embodiment and the modifications described above. For example, some of the through-holes shown in the above-described exemplary embodiment may have the configuration shown in FIG. 8, or have shapes shown in FIGS. 9 and 10.

In the case of forming a plurality of through-holes, some of the through-holes may be each a through-hole (e.g., a cylindrical through-hole) having a constant cross-sectional area from one end to the other end. In other words, it is not necessarily that all through-holes are formed into a shape having a smallest section and a largest section between one end and the other end.

The main body section may have any of various shapes other than the substantially truncated quadrangular pyramid shape illustrated in the above-described exemplary embodiment. For example, the main body section may take a truncated cone shape, or may be a cylindrical shape or a prismatic shape. The main body section may have a recess or a step portion.

The circuit board of the present disclosure may be a flat-shaped circuit board other than the three-dimensional circuit board illustrated in the above-described exemplary embodiment.

The circuit board may have any number of through-holes. The through-holes may be disposed at any places and may be arbitrarily changed in other specifications. The through-hole may be a polygon in contour and may be a slot in shape.

The main body section, the wiring pattern, and other detailed specifications (e.g., shape, size, and layout) may be suitably changed.

### INDUSTRIAL APPLICABILITY

The present disclosure provides a circuit board that prevents a wiring pattern from peeling off a main body section with increased reliability. Thus, the art of the present disclosure can be applied to electronic devices that are designed for mobile use and other purposes, and are potentially subject to impact.

### REFERENCE MARKS IN THE DRAWINGS

10: three-dimensional circuit board (circuit board)
20: main body section
21: top wall (first wall)
22: peripheral wall (second wall)
23: surface
24: outer surface (surface adjacent to one end)
25: inner surface (surface adjacent to other end)
30: wiring pattern
31, 31a, 31b: land section
32, 32a, 32b: wiring section
33: one surface wiring pattern (first surface wiring pattern)
34: other surface wiring pattern (second surface wiring pattern)
35, 35A: inner surface wiring pattern
40: through-hole
40a: one end (first end)
40b: other end (second end)
41: inner surface
42: smallest section
100: electronic component
400, 400B, 400C: through-hole in which smallest section is formed

## Claims

1. A circuit board comprising:
a main body section including a first wall and a second wall connected to and intersected with the first wall, the first wall being to be mounted with an electronic component, at least a surface of the main body section having insulating properties;
a wiring pattern disposed on the surface of the main body section; and
a through-hole formed in a site of the main body section, the site being provided with the writing pattern, wherein:
the through-hole has a first end and a second end,
the wiring pattern includes a first surface wiring pattern and an inner surface wiring pattern, the first surface wiring pattern being on a first surface with the first end among the surface of the main body section, the inner surface wiring pattern being connected to the first surface wiring pattern and being on an inner surface of the through-hole,
the through-hole includes a smallest section, the smallest section being smallest in area of a cross section of the through-hole, the cross section being perpendicular to a passing-through direction from the first end to the second end, and
the inner surface wiring pattern is provided from the first end to a position beyond the smallest section.

2. The circuit board according to claim 1, wherein the wiring pattern further includes a second surface wiring pattern connected to the inner surface wiring pattern, the second surface wiring pattern being on a second surface with the second end among the surface of the main body section.

3. The circuit board according to either claim 1 or 2, wherein:
the first surface wiring pattern includes a land section and a wiring section connected to the land section, the land section being to be mounted with the electronic component, and
the through-hole is formed in a site of the main body section, the site being provided with the land section.

4. The circuit board according to claim 3, wherein the through-hole is positioned in an area around the electronic component when the electronic component is mounted in the land section.

5. The circuit board according to either claim 1 or 2, wherein:
the first surface wiring pattern includes a land section and a wiring section connected to the land section, the land section being to be mounted with the electronic component, and
the through-hole is formed in a site of the main body section, the site being provided with the wiring section.

6. The circuit board according to claim 5, wherein the land section is disposed on the first wall, and the wiring section is disposed on the second wall.

7. The circuit board according to claim 1, wherein the first surface wiring pattern is disposed on both the first wall and the second wall.
